# EUROPEAN PATENT APPLICATION

(11) **EP 4 261 733 A1**
(43) Date of publication of application: **18.10.2023**
(21) Application number: 23166419.4
(22) Date of filing: 03.04.2023
(51) Int. Cl.: G06F 30/20, B60W 60/00, G06F 30/12

(54) **SIMULATION METHOD, COMPUTING DEVICE AND STORAGE MEDIUM**

(30) Priority: 12.04.2022 CN 202210381098
(71) Applicant: Beijing Tusen Zhitu Technology Co., Ltd., Beijing 100016 (CN)
(72) Inventor: FU, Chengbing, Beijing, 100016 (CN); FENG, Xingyue, Beijing, 100016 (CN)
(74) Representative: Murgitroyd & Company

(57) **Abstract**

The present disclosure relates to a simulation method, a computing device, and a storage medium for use in automatic and periodical generation of environmental entities around a target test object in a simulation platform, thereby improving the simulation test efficiency. The simulation method comprises: generating a main entity in a simulation platform; acquiring simulation parameters of environmental entities, the simulation parameters comprising update periods of the environmental entities and a number constraint of the environmental entities in a preset area within each update period; determining, according to the number constraint, an expected number of the environmental entities in the preset area within each update period; and generating, according to the simulation parameters and the expected number, a corresponding number of the environmental entities in the preset area within each update period so as to enable the newly-generated environmental entities to run in the simulation platform.

## Description

The present disclosure claims priority to Chinese patent application No. 202210381098.4, titled "VIRTUAL PLATFORM SIMULATION METHOD, COMPUTING DEVICE AND STORAGE MEDIUM", filed on April 12, 2022.

### TECHNICAL FIELD

The present disclosure relates to the field of computer technologies, and in particular to a simulation method, a computing device, and a storage medium.

### BACKGROUND

Autonomous vehicles are typically subjected to a simulation test in a simulation system before they are tested or run. The autonomous driving simulation system comprises representation of autonomous vehicles to be tested (which can be referred as main entity) and representation of objects other than the various autonomous vehicles, i.e., non player characters (NPCs), such as pedestrians, bicycles, motorcycles, and motor vehicles, which are collectively referred to as environmental entities.

The current autonomous driving simulation system mainly defines all behaviors of all NPCs in a limited road section within a limited time period in a manual editing manner, or reproduces all behaviors of all NPCs in a limited road section within a limited time period in a road test in a manner of importing data acquired in the road test of an autonomous vehicle. However, the amount of data imported by manual editing and from a road test is very limited, and is limited by the number of scenes encountered by human thinking and road tests, so that simulation test resources cannot be effectively utilized.

### DISCLOSURE OF THE INVENTION

The present disclosure provides a simulation method, a computing device, a storage medium, and a vehicle so as to solve or at least solve the above-mentioned problems.

In a first aspect, an embodiment of the present disclosure provides a simulation method, comprising:
generating a main entity in a simulation platform, the main entity is configured to run based on a calculation result of to-be-tested algorithms;
acquiring simulation parameters of environmental entities, the simulation parameters comprising update periods of the environmental entities and a number constraint of the environmental entities in a preset area where the main entity is located within each update period;
determining, according to the number constraint, an expected number of the environmental entities in the preset area where the main entity is located within each update period; and
generating, according to the simulation parameters, a corresponding number of the environmental entities in the preset area of the main entity within each update period so as to enable the newly-generated environmental entities to run in the simulation platform.

In a second aspect, an embodiment of the present disclosure provides a computing device comprising one or more processors, and a memory having one or more programs stored thereon, wherein the one or more programs, when executed by the one or more processors, cause the computing device to implement the virtual platform simulation method according to the present disclosure.

In a third aspect, an embodiment of the present disclosure provides a computer-readable storage medium having a program stored thereon, wherein the program, when executed by a processor, causes the computing device to implement the virtual platform simulation method according to the present disclosure.

According to the technical solution of the present disclosure, provided is a simulation platform for automatically verifying an unmanned system according to a test map. Through the simulation platform, simulation parameters of environmental entities can be automatically generated, and a variety of environmental entities are generated in a preset area of a main entity within each update period according to the simulation parameters, so that the diversity of tests and the full process automation are improved. The simulation platform of the present disclosure is used as a supplement for manually created test cases. It simulates the traffic conditions in the real world, generates various traffic scenes on the basis of different combinations of entities, driving habits, traffic pressure and maps, and simulates various driving scenes in the real world by means of the random scenes so as to achieve the purpose of testing the autonomous driving system of the main entity.

Moreover, the interaction behaviors between the main entity and the environmental entities, and between one environmental entity and other environmental entities in the present disclosure can be automatically generated. The main entity can continuously run, and can automatically restart and continuously execute the test after an abnormality occurs. After the environmental entities are generated, the vehicle may run according to other default settings such as a preset speed and a driving habit with reference to the surrounding environment. According to the configured simulation parameters, all environmental entities may generate, disappear and randomly interact with other environmental entities and the main entity. The simulation result can be automatically stored, and particularly, the simulation result before and after the abnormality occurs may be stored with emphasis so as to analyze the reason of the abnormality.

### BRIEF DESCRIPTION OF THE DRAWINGS

In order to more clearly illustrate the embodiments of the present disclosure or technical solutions in the prior art, the drawings used in the description of the embodiments or prior art will be briefly described below. It is apparent that other drawings can be derived from these drawings by those of ordinary skill in the art without making creative efforts.
FIG. 1 shows a schematic diagram of a vehicle 100 according to an embodiment of the present disclosure;
FIG. 2 shows a flowchart of a simulation method 200 according to an embodiment of the present disclosure;
FIG. 3 shows a schematic diagram of a simulation platform configuration interface according to an embodiment of the present disclosure;
FIG. 4 shows a schematic diagram of a main entity and environmental entities according to an embodiment of the present disclosure; and
FIG. 5 shows a block diagram of a computing device 500 according to an embodiment of the present disclosure.

### DETAILED DESCRIPTION

The technical solutions in the embodiments of the present disclosure will be clearly and completely described below with reference to the accompanying drawings. It is obvious that the described embodiments are only part of the embodiments of the present disclosure rather than all of the embodiments. Based on the embodiments in the present specification, various variations and modifications can be made by those of ordinary skill in the art, and all technical solutions obtained by equivalent modifications shall fall within the protection scope of the present disclosure.

To facilitate a clear description of the technical solutions of the embodiments of the present disclosure, in the embodiments of the present disclosure, the terms "first", "second", etc., are used to distinguish the same items or similar items with basically same functions or actions, and those skilled in the art will appreciate that the terms "first", "second", etc., are not intended to limit the number and execution order.

The term "and/or" used herein is merely an associative relationship describing associated objects, and refers to that there may be three relationships, for example, A and/or B, may refers to that: A is present alone, A and B are present simultaneously, and B is present alone. In addition, the character "/" used herein generally indicates an "or" relationship between the associated objects.

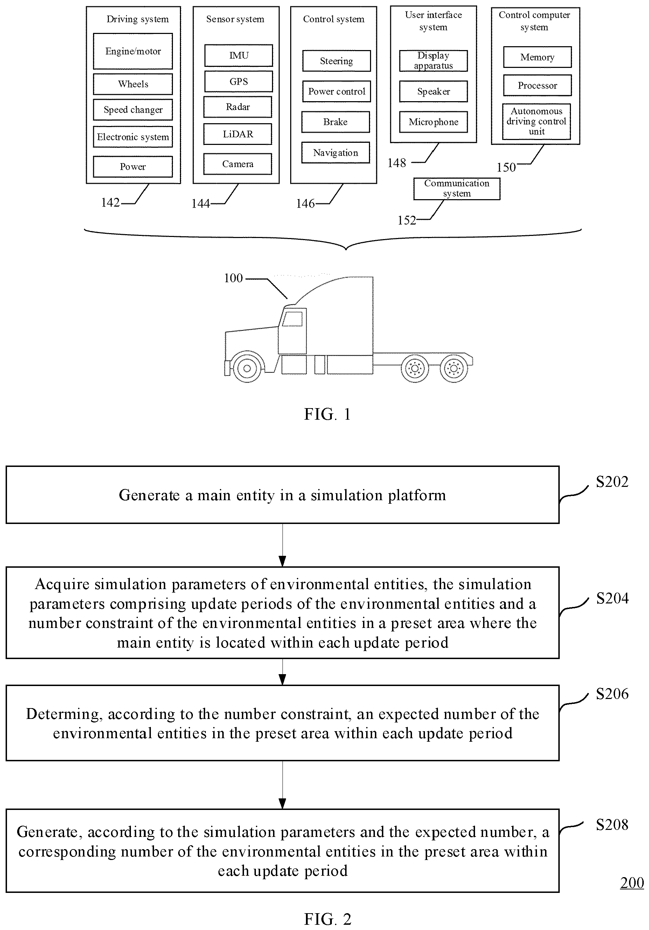

FIG. 1 is a schematic diagram of a vehicle 100 in which various techniques disclosed herein are implemented. The vehicle 100 may be a car, a truck, a motorcycle, a bus, a watercraft, an airplane, a helicopter, a hay mower, an excavator, a snowmobile, an aircraft, a recreational vehicle, an amusement park vehicle, a farm apparatus, a construction apparatus, a tram, a golf cart, a train, a trolley bus or other vehicles. The vehicle 100 can be operated fully or partially in an autonomous driving mode. The vehicle 100 can control itself in the autonomous driving mode. For example, the vehicle 100 can determine a current state of the vehicle and a current state of an environment in which the vehicle is located, determine a predicted behavior of at least one other vehicle in this environment, and determine a trust level corresponding to a likelihood that the at least one other vehicle performs the predicted behavior, and thus the vehicle 100 can control itself based on the determined information. The vehicle 100, when in the autonomous driving mode, can be operated without human interaction.

The vehicle 100 may comprise various vehicle systems, such as a driving system 142, a sensor system 144, a control system 146, a user interface system 148, a control computer system 150 and a communication system 152. The vehicle 100 may comprise more or fewer systems, each of which may comprise a plurality of units. Further, each system and unit of the vehicle 100 can be interconnected. For example, the control computer system 150 can be in data communication with one or more of the systems 142-148, and 152. Thus, one or more of the described functions of the vehicle 100 may be divided into additional functional or physical components or combined into a fewer number of functional or physical components. In a still further example, additional functional or physical components may be added to the example shown in FIG. 1.

The driving system 142 may comprise a plurality of operable components (or units) that provide kinetic energy for the vehicle 100. In one embodiment, the driving system 142 may comprise an engine or a motor, wheels, a speed changer, an electronic system, and power (or a source of power). The engine or motor may be any combination of the following apparatuses: an internal combustion engine, an electrical machine, a steam engine, a fuel cell engine, a propane engine or other forms of engines or motors. In some embodiments, the engine may convert a source of power into mechanical energy. In some embodiments, the driving system 142 may comprise a variety of engines or motors. For example, a hybrid electric vehicle may comprise a gasoline engine and a motor, and may also comprise other combinations.

The wheels of the vehicle 100 may be standard wheels. The wheels of the vehicle 100 may be in a variety of forms including single wheel, dual wheel, three wheel or four wheel forms, such as four wheels on a car or a truck. Other numbers of wheels are possible, such as six or more wheels. One or more wheels of the vehicle 100 may be operated to rotate in a direction different from the other wheels. The wheel may be at least one wheel fixedly connected with the speed changer. The wheel may comprise a combination of metal and rubber or a combination of other substances. The speed changer may comprise a unit operable to transmit mechanical power of the engine to the wheels. For this purpose, the speed changer may comprise a gearbox, a clutch, a differential gear and a propeller shaft. The speed changer may also comprise other units. The propeller shaft may comprise one or more axles that mate with the wheels. The electronic system may comprise a unit for transmitting or controlling electronic signals of the vehicle 100. These electronic signals can be used to activate a plurality of lights, servos, motors and other electronically driven or controlled apparatuses in the vehicle 100. The source of power may be an energy source that wholly or partially powers an engine or a motor. That is, the engine or the motor can convert the source of power into mechanical energy. For example, the source of power may comprise gasoline, petroleum, petroleum-based fuels, propane, other compressed gas fuels, ethanol, fuel cells, solar panels, batteries and other sources of electrical energy. The source of power may additionally or optionally comprise any combination of a fuel tank, a battery, a capacitor or a flywheel. The source of power may also provide power to other systems of the vehicle 100.

The sensor system 144 may comprise a plurality of sensors for sensing information about the environment and conditions of the vehicle 100. For example, the sensor system 144 may comprise an inertial measurement unit (IMU), a global positioning system (GPS) transceiver, a radar (RADAR) unit, a laser rangefinder/LiDAR unit (or other distance measurement apparatus), an acoustic sensor, and a camera or image capture apparatus. The sensor system 144 may comprise a plurality of sensors (e.g., oxygen (O₂) monitors, fuel gauge sensors, and engine oil pressure sensors) configured for monitoring the vehicle 100. The sensor system 144 may also be equipped with other sensors. One or more sensors comprised in the sensor system 144 can be driven individually or collectively to update the location, orientation, or both of the one or more sensors.

In some embodiments, each sensor acquires data through a hardware trigger or a software trigger, with different sensors having different trigger frequencies, i.e., different data acquisition frequencies, and correspondingly having different data acquisition periods. For the hardware trigger, a trigger source uses a pulse per second signal sent by Novatel as a trigger source signal, and adjusts the trigger source signal according to trigger frequencies required by different sensors to generate a trigger signal and send the trigger signal to a corresponding sensor so as to trigger the corresponding sensor to acquire data. Optionally, the trigger frequency of the camera is 20 HZ, the trigger frequency of the LiDAR is 1 HZ or 10 HZ, and the trigger frequency of the IMU is 100 HZ, but it is certainly not limited to this.

The IMU may comprise a combination of sensors (e.g., an accelerometer and a gyroscope) for sensing location and direction changes of the vehicle 100 based on inertial acceleration. The GPS transceiver may be any sensor for estimating the geographic location of the vehicle 100. For this purpose, the GPS transceiver may comprise a receiver/a transmitter to provide location information of the vehicle 100 relative to the earth. It should be noted that GPS is an example of a global navigation satellite system, and therefore, in some embodiments, the GPS transceiver may be replaced with a BeiDou satellite navigation system transceiver or a Galileo satellite navigation system transceiver. The radar unit may use radio signals to sense an object in the environment in which the vehicle 100 is located. In some embodiments, in addition to sensing the object, the radar unit may also be configured for sensing the speed and heading of an object approaching the vehicle 100. The laser rangefinder or LiDAR unit (or other distance measurement apparatuses) may be any sensor that uses laser light to sense an object in the environment in which the vehicle 100 is located. In one embodiment, the laser rangefinder/LiDAR unit may comprise a laser source, a laser scanner, and a detector. The laser rangefinder/LiDAR unit is configured for operating in either a consecutive (e.g., using heterodyne detection) or inconsecutive detection mode. The camera may comprise an apparatus for capturing a plurality of images of the environment in which the vehicle 100 is located. The camera may be a still image camera or a dynamic video camera.

The control system 146 is configured for controlling the operation of the vehicle 100 and components (or units) thereof. Accordingly, the control system 146 may comprise various units, such as a steering unit, a power control unit, a brake unit, and a navigation unit.

The steering unit may be a combination of machines that adjust the heading of the vehicle 100. The power control unit (which may be, e.g., an accelerator) may be, for example, configured for controlling the operating speed of the engine and thereby the speed of the vehicle 100. The brake unit may comprise a combination of machines for decelerating the vehicle 100. The brake unit may use friction to decelerate the vehicle in a standard manner. In other embodiments, the brake unit may convert kinetic energy of the wheel into electric current. The brake unit may be in other forms as well. The navigation unit may be any system that determines a driving path or route for the vehicle 100. The navigation unit may also dynamically update the driving path as the vehicle 100 proceeds. The control system 146 may additionally or optionally comprise other components (or units) not shown or described.

The user interface system 148 can be configured to allow the interaction between the vehicle 100 and external sensors, other vehicles, other computer systems, and/or users of the vehicle 100. For example, the user interface system 148 may comprise a standard visual display apparatus (e.g., a plasma display, a Liquid Crystal Display (LCD), a touch screen display, a head-mounted display, or other similar displays), a speaker or other audio output apparatuses, a microphone, or other audio input apparatuses. For example, the user interface system 148 may also comprise a navigation interface and an interface to control the internal environment (e.g., temperature or fans) of the vehicle 100.

The communication system 152 may provide the vehicle 100 with a way to communicate with one or more devices or other vehicles in the vicinity. In one exemplary embodiment, the communication system 152 may communicate with one or more devices directly or through a communication network. The communication system 152 may be, for example, a wireless communication system. For example, the communication system may use 3G cellular communication (e.g., CDMA, EVDO or GSM/GPRS) or 4G cellular communication (e.g., WiMAX or LTE), and may also use 5G cellular communication. Optionally, the communication system may communicate with a Wireless Local Area Network (WLAN) (e.g., using WIFI^{®}). In some embodiments, the communication system 152 may communicate directly with one or more devices or other vehicles around, for example, using infrared, Bluetooth^{®} or ZIGBEE. Other wireless protocols, such as various vehicle-mounted communication systems, are also within the scope of the present disclosure. For example, the communication systems may comprise one or more Dedicated Short Range Communication (DSRC) apparatuses, V2V apparatuses or V2X apparatuses that may be in data communication publicly or privately with vehicles and/or roadside stations.

The control computer system 150 can control some or all of the functions of the vehicle 100. An autonomous driving control unit of the control computer system 150 can be configured to identify, evaluate and avoid or eliminate potential obstacles in the environment in which the vehicle 100 is located. In general, the autonomous driving control unit can be configured to control the vehicle 100 in the absence of a driver or to provide assistance to the driver in controlling the vehicle. In some embodiments, the autonomous driving control unit is configured to combine data from a GPS transceiver, a radar, a LiDAR, a camera and other vehicle systems to determine a travel path or trajectory of the vehicle 100. The autonomous driving control unit can be activated to enable the vehicle 100 to be driven in an autonomous driving mode.

The control computer system 150 may comprise at least one processor (which may comprise at least one microprocessor) that executes processing instructions (i.e., machine-executable instructions) stored in a non-volatile computer readable medium (e.g., a data storage apparatus or a memory). The memory stores therein at least one machine-executable instruction. The processor executes the at least one machine-executable instruction to implement functions of the map engine, the positioning module, the sensing module, the navigation or routing module, the automatic control module, and the like. The map engine and the positioning module are configured for providing map information and positioning information. The sensing module is configured for sensing, according to the information acquired by the sensor system and the map information provided by the map engine, things in the environment where the vehicle is located. The navigation or routing module is configured for planning a traveling path for the vehicle according to the processing results of the map engine, the positioning module, and the sensing module. The automatic control module inputs, analyzes and converts decision information of the module such as the navigation or routing module into a control command for a vehicle control system, outputs the control command, and sends the control command to a corresponding component in the vehicle control system through a vehicle-mounted network (for example, an in-vehicle electronic network system which is achieved through a controller area network (CAN) bus, a local area Internet, a multimedia directional system, and the like), so as to achieve automatic control for the vehicle. The automatic control module can also acquire information of all components in the vehicle through the vehicle-mounted network.

The control computer system 150 may also be a plurality of computing apparatuses that distributively control components or systems of the vehicle 100. In some embodiments, the memory may contain processing instructions (e.g., program logic) that are executed by the processor to implement various functions of the vehicle 100. In one embodiment, the control computer system 150 can be in data communication with the systems 142, 144, 146, 148, and/or 152. The interfaces of the control computer system are configured to facilitate data communication between the control computer system 150 and the systems 142, 144, 146, 148, and 152.

The memory may also comprise other instructions, including instructions for data transmission, data reception, interaction, or control of the driving system 142, the sensor system 144, the control system 146 or the user interface system 148.

In addition to storing processing instructions, the memory may store a variety of information or data, such as image processing parameters, road maps and path information. The information may be used by the vehicle 100 and the control computer system 150 during operation of the vehicle 100 in an autonomous mode, a semi-autonomous mode and/or a manual mode.

Although the autonomous driving control unit is shown as separated from the processor and the memory, it should be understood that, in some embodiments, some or all of the functions of the autonomous driving control unit can be implemented using program code instructions residing in one or more memories (or data storage apparatuses) and can be executed by the one or more processors, and that the autonomous driving control unit can be implemented using the same processor and/or memory (or data storage apparatus) in some cases. In some embodiments, the autonomous driving control unit may be implemented, at least in part, using various application-specific circuit logics, various processors, various Field Programmable Gate Arrays ("FPGAs"), various Application-Specific Integrated Circuits ("ASICs"), various real-time controllers and hardware.

The control computer system 150 may control functions of the vehicle 100 based on inputs received from various vehicle systems (e.g., the driving system 142, the sensor system 144 and the control system 146) or inputs received from the user interface system 148. For example, the control computer system 150 may use inputs from the control system 146 to control the steering unit to avoid obstacles detected by the sensor system 144. In one embodiment, the control computer system 150 may be configured to control various aspects of the vehicle 100 and systems thereof.

Although various components (or units) integrated into the vehicle 100 are shown in FIG. 1, one or more of the components (or units) may be mounted on the vehicle 100 or separately associated with the vehicle 100. For example, the control computer system may exist partially or wholly independent of the vehicle 100. Thus, the vehicle 100 can exist in the form of separated or integrated device units. The device units constituting the vehicle 105 can communicate with each other in wired or wireless communication. In some embodiments, additional components or units may be added to various systems, or one or more components or units above (e.g., the LiDAR or radar as shown in FIG. 1) may be removed from the systems.

The autonomous vehicle needs to be subjected to a virtual platform (i.e., simulation platform) simulation test in addition to a real vehicle test. FIG. 2 is a flowchart of a virtual platform simulation method 200 according to an embodiment of the present disclosure. As shown in FIG. 2, the method 200 comprises:
Step S202, generating a main entity corresponding to algorithms to be tested in a simulation platform, the main entity being configured for running in a simulation platform based on the calculation result of the to-be-tested algorithms, the algorithms comprise autonomous driving algorithms, thus the behavior of the main entity can represent the calculation result of the to-be-tested algorithms;
Step S204, acquiring simulation parameters of environmental entities, the simulation parameters comprising update periods of the environmental entities in the test process of algorithms and a number constraint of the environmental entities in a preset area where the main entity is located within each update period;
Step S206, determining, according to the number constraint, an expected number of the environmental entities in the preset area where the main entity is located within each update period; and
Step S208, generating, according to the simulation parameters, a corresponding number of the environmental entities in the preset area where the main entity is located at each update period, so as to enable the newly-generated environmental entities to run in the simulation platform. Step 208 further comprises: generating, according to the simulation parameters and the expected number, a corresponding number of the environmental entities in the preset area at each update period.

According to some embodiments, the simulation platform is a computing device or server or cluster of servers, the platform has a display interface in which a simulation scene and agents in the simulation scene are displayed. The simulation scene comprises static information required for simulation, such as a test map, and the test map is displayed according to road information acquired by a real vehicle, the test map is for example a high-precision map. Testers can select a test map and map version of test areas in advance in the inputting interface. The road information comprises, but is not limited to, road signs, road attributes, lane lines, speed limit information, slope information, road material, and road patency. Among them, the road signs may be marked in segments at intervals of a preset distance, or respectively marked according to the road name of the actual environment, and may also be marked in segments according to the time period of acquiring the data by the real vehicle. The road attributes include, but are not limited to, highways, urban roads, ramps, T-junctions, crossroads, roundabouts, tunnels, etc., wherein highways may comprise one-level highways, two-level highways, and even three-level or four-level highways. The speed limit information comprises the highest speed, the lowest speed, and the like. The slope information comprises a slope angle, a slope length, and the like. The road material comprises a cement road, an asphalt road, a sandy road and the like. The road patency comprises whether water accumulation and potholes exist, and the like.

In addition, images of infrastructure on the road and buildings on both sides of the road are also displayed in the test map. The infrastructure comprises, but is not limited to, traffic lights, road posts, traffic cones, barricades, and the like. The image of buildings comprises the appearance of buildings, where different buildings are rendered in different colors to effectively distinguish buildings close to each other. The present disclosure may also provide simulation parameters of the infrastructure, including, but not limited to, setting the appearance location, the appearance frequency and the change rule of the traffic light, the appearance frequency of traffic cones, the universal dimension of each facility and the like, so that traffic cones may appear on the road section that originally does not have traffic cones in the high-precision map so as to test the avoidance processing capacity of the main entity on the traffic cones.

The simulation platform also has inputting interface for users inputting, selecting, and determining the configuration of various constraints, to further generating different simulation parameters. Further, the simulation platform comprises at least one of an inputting device configured for providing the inputting interface, a display device configured for providing the display interface, or a simulation device configured for testing or running the autonomous driving algorithm. The simulation platform may have a virtual autonomous driving system corresponding to autonomous driving system of the Vehicle 100 in Fig. 1, the virtual autonomous driving system simulates the autonomous driving system of Vehicle 100 at the software level. Or the simulation platform may have the same algorithm as the autonomous driving algorithm of Vehicle 100. The simulation platform runs the same algorithm to test the autonomous driving algorithm of Vehicle 100 (also known as test Vehicle 100) and determine where the representation of the autonomous driving vehicle is located in the simulation scene at different times. The autonomous driving algorithms include, but are not limited to, a positioning algorithm, a sensing algorithm, a decision-making algorithm and a control algorithm so as to control the autonomous running of the vehicle in the simulation scene, such as advancing, reverse parking, obstacle avoidance, overriding, lane changing, emergency stop, and side parking.

According to some embodiments, agents comprise a main entity and environmental entities, the main entity and the environmental entities both can be represents as two-dimensional structure or three-dimensional structure such as 2D box or 3D box. Vehicles can also be represented as a main body frame at the upper part and a tire structure at the lower part. Further, the present disclosure can pre-configure different display structures for different types of main entities and environmental entities (such as different kind of vehicles or pedestrians), and display corresponding entity styles as needed. The main entity represents an autonomous vehicle to be tested, such as the vehicle 100 of FIG. 1. The main entity is a display model or representation of a vehicle and can be regarded as a virtual vehicle. The main entity runs in the simulation platform according to calculation result of the virtual autonomous driving system or autonomous driving algorithms equipped in the simulation platform.

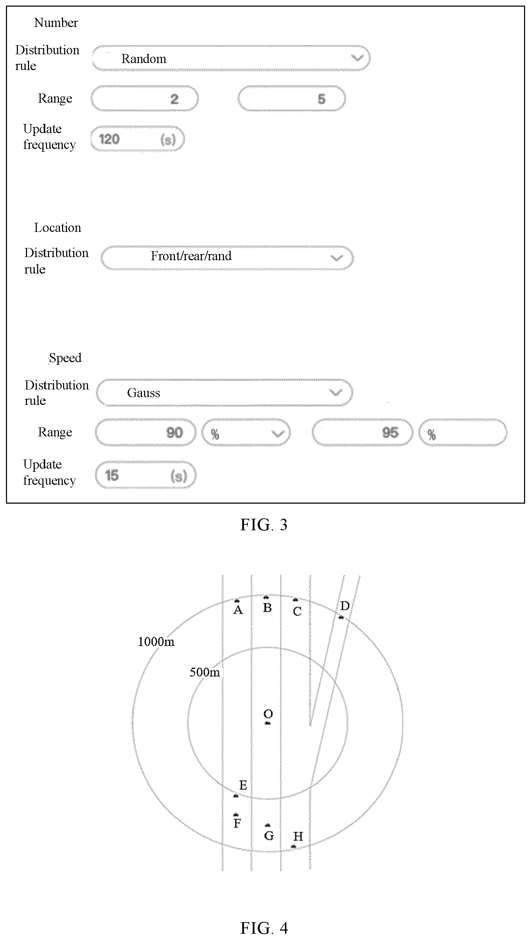

The environmental entities comprise various mobile NPCs( such as pedestrians and environmental vehicles) and static NPCs. The environmental entities are also display model or representation of environmental vehicles or pedestrians, and can be regarded as virtual environmental vehicle or virtual pedestrians. The present disclosure is configured with simulation parameters of the environmental entities in advance, for example, configuration of multiple constraints the simulation parameters of the environmental entities can be generated by input, drop-down box option, button option, etc. in inputting interface of the simulation platform as shown in FIG. 3. The simulation parameters include, but are not limited to, update period, number distribution, location constraint, type constraint, dimension constraint, initial speed constraint, target speed constraint, acceleration constraint, deceleration constraint, and driving habit parameters of the environmental entities. Further, the simulation parameters can also comprise the expected number value, position coordinates, type ID, dimension value, initial speed value, target speed value, acceleration value, deceleration value based on each constraint. Or, the multiple constraints can be collectively called simulation constraints, and the expected number value, position coordinates, type ID, dimension value, initial speed value, target speed value, acceleration value, deceleration value based on each constraint, driving habit can be collectively called simulation parameters.

Among them, the update period (also called generating frequency) represents how often a batch of new environmental entities are generated during the test of the algorithms. The update period may be a fixed value or a dynamically changing value, for example, a batch of new environmental entities are generated at the current interval of 100 seconds, and a batch of new environmental entities are generated at the next interval of 120 seconds. The update period can further comprise a generating frequency distribution, generating frequency distribution represents the distribution rule with which the values of multiple consecutive generating frequencies comply. The distribution rule of the present disclosure may adopt the distribution rule commonly used in the art, including, but not limited to, Gaussian distribution, fixed distribution, random distribution, etc. It is also possible to choose whether the distribution rule is strictly followed, i.e., to set a strict option, if YES, strictly followed, otherwise, there may be appropriate deviations.

The number constraint comprises a range of values for the expected number of the environmental entities for each update period, and a distribution rule with which a plurality of expected number values of a plurality of update periods are required to comply. That is, the number constraint comprises the range of the number of NPCs expected to exist in each update period, and the distribution rule followed by the NPCs number. The range of values comprises maximum and minimum values of the NPCs number.

According to some embodiments, the step S206 of generating, according to the number constraint, an expected number of the environmental entities in the preset area where the main entity is located within each update period comprises: at the arrival of an update moment of each update period, determining in advance, according to the number constraint, an expected number of the environmental entities in the preset area where the main entity is located within the update period; or before the main entity starts to run, determining, according to the number constraint, the expected number of the environmental entities in the preset area where the main entity is located within each update period so as to obtain a plurality of expected numbers corresponding to a plurality of update periods in advance.

That is, at the arrival of each period time (for example, at the arrival of the initial moment of each update period, which is, the end time of the previous update period), a new number is randomly generated as the expected number within the update period according to the range of values and the distribution rule. Or, numbers within a plurality of consecutive update periods may be randomly generated in advance according to the number range and the distribution rule, and the corresponding relationship between the serial numbers of the update periods and the generated numbers is stored. When the corresponding update period comes, the obtained corresponding number is the expected number of the NPCs within the period.

According to some embodiments, the step S208 of generating, according to the simulation parameters, a corresponding number of the environmental entities in the preset area where the main entity is located within each update period comprises:
A1: calculating, within each update period, an actual number of the environmental entities in the preset area of the main entity and a difference value between the actual number and the expected number;
A2: generating, in response to the difference value being a positive number, new environmental entities with a number of the difference value in the preset area of the main entity; and
A3: postponing, in response to the difference value being a negative number, the update operation of current update period, and determining, according to the actual number of the environmental entities in the preset area of the main entity within the current update period, whether to generate a new environmental entity. Step A3 can also comprise: waiving or not performing, in response to the difference value being a negative number, the update operation of the current update period, and determining whether to execute the update operation within the next update period. The update operation means generating new environmental entity.

For example, when the update moment of the first period comes, it is assumed that a number 5 is randomly generated, which represents that 5 environmental entities are expected to exist in a preset area of the main entity within the period, at the moment, the number of the existing environmental entities may be calculated, and if the number is less than the expected number 5, a corresponding number of new environmental entities are generated according to the difference value. If the number is equal to the expected number 5, the current environmental entities are kept unchanged, and during the next period, whether new environmental entities need to be added is determined according to the expected number of the next period. If the number is more than the expected number 5, some environmental entities are not required to be set to disappear immediately, and the existing environmental entities are kept unchanged, and after the existing environmental entities disappear naturally, whether new environmental entities need to be added and the number of new environmental entities needed are determined according to the actual number of environmental entities after their disappearance. Of course, if the environmental entities within the period do not disappear naturally, that is, the number of the environmental entities in the preset area of the vehicle is greater than the expected number 5, some environmental entities are not forced to disappear, and determines whether to execute the update operation in the next update period.

In brief, it is known that the expected number of NPCs in the period is 5, and if the number of NPCs at the beginning of the period is 2, three NPCs are generated in the period; if the number of NPCs at the beginning of the period is 6, no new NPC is supplemented after one NPC naturally disappears, and if no NPC naturally disappears in the current period, the next update period is entered to determine whether to execute the update operation in the next update period. The above approach may be as close as possible to the vehicle change logic in the actual road.

When the update moment of the second period comes, it is assumed that a number 7 is randomly generated, which represents that 7 environmental entities are expected to exist in a preset area of the main entity within the period. Similarly, new environmental entities are generated or an number of the existing environmental entities is kept unchanged according to the determination logic of the first update period, which is not described herein again.

It can be seen that when the number of environmental entities in the preset area of the main entity is insufficient (less than the expected number), new environmental entities will be generated. The newly-generated environmental entities are located in the preset area of the main entity and do not crash or overlap with other agents. However, when any one of the following cases occurs, the environmental entities may disappear from the simulation platform: a crash, driving out of a test map, driving out of the preset area of the main entity.

According to some embodiments, the preset area comprises a circular area centered on the main entity or a rectangular area centered on the main entity, wherein the radius of the circular area may be 500-1000 m, and the length or width of the rectangular area may be 1000-2000 m. As shown in FIG. 4, the main entity O is located at the center, and eight environmental entities A-H are disposed in the same lane and the left and right lanes of the main entity O, respectively.

According to some embodiments, the location constraint comprises at least one of the following: a relative location of each environmental entity relative to the main entity when each environmental entity being generated, and an offset value of each environmental entity relative to a lane center when each environmental entity being generated, and the conditions or distribution rlue with which the relative position and offset value should comply. Among them, the relative location comprises at least one of the following: left front, straight ahead, right front, left side, right side, left back, directly behind, and right back, for example, the front and rear of the left lane, the front and rear of this lane, and the front and rear of the right lane. The relative location may also be set to a random location.

According to some embodiments, the environmental entities may be generated entirely in the same lane of the main entity, or partly in the same lane and partly in the opposite lane, which is not limited in the present disclosure. The environmental entities may be entirely generated on the lane centerline, or may make an offset from the lane centerline by a distance value which may exhibit a specific distribution rule as described above. For example, NPC No. 1 is 10 cm away from the lane center, NPC No. 2 is 15 cm away from the lane center, and so on.

According to some embodiments, the type constraint comprises conditions to be satisfied by the type of the newly-generated environmental entities, and specifically may comprise which types of environmental entities need to exist in the period, and the number of environmental entities with different type. The types of environmental entities comprise at least one of pedestrians and vehicles. Vehicles comprise, but are not limited to, heavy trucks, light trucks, cars, off-road vehicles, motorcycles, tricycles, electric vehicles, trucks, fire trucks, ambulances, police cars, road maintenance vehicles, and the like.

According to some embodiments, the dimension constraint comprises conditions to be satisfied by a dimension of the newly-generated environmental entities, the dimension including at least one of a pedestrian size and a vehicle dimension. In the present disclosure, the length, width and height of each NPC are generated in a fixed value or in a distribution manner, and the dimension of each NPC is not changed after the NPC is generated. For example, the range of dimension changes of the NPC vehicles is determined according to the dimensions of various vehicles on the market at present, and various NPC vehicle models are generated in the range. Similarly, the range of size changes of the pedestrians is determined according to the average body size of human in the tested area, and various pedestrian models are generated in the range. If the type of each vehicle to be generated is known, the dimension of a corresponding type of vehicle can be generated according to the conventional range of dimension changes of each type of vehicles. The dimensions of different vehicles satisfy a certain distribution.

In addition, although different types of vehicles have correspondingly defined dimensions, many goods-carrying vehicles may have different widths, heights, and lengths. In order to approximate the real vehicle situation as much as possible, the dimension range of the NPC vehicles may be generated according to the dimension range of the existing goods-carrying vehicles during the simulation of the NPC vehicles in the present disclosure. Moreover, considering that a vehicle carrying special goods, such as a truck carrying reinforcing bars which may extend far beyond the vehicle body, is inevitably encountered while a vehicle is running, therefore, in the simulation scene of the present disclosure, a plurality of bars are randomly displayed on the body of a goods-carrying vehicle within a certain update period to simulate the shape of the reinforcing bars and the location of the reinforcing bars relative to the vehicle so as to detect the avoidance capacity of the autonomous vehicle facing these vehicles carrying special goods.

According to some embodiments, the initial speed constraint comprises a speed range and a distribution rule when each environmental entity is generated, and the target speed constraint comprises a speed range and a distribution rule when each environmental entity reaches a uniform motion. The speed range comprises the maximum value and the minimum value of the initial speed values of a plurality of environmental entities, and the distribution rule represents the rule followed by the initial speed values of the plurality of environmental entities. Similar to the number distribution, within each update period, one or more numbers can be randomly generated according to the speed range and distribution rule of the initial speed as the initial speed of the newly-generated environmental entities. In addition, one or more numbers can be randomly generated according to the speed range and the distribution rule of the target speed as the target speed of the newly-generated environmental entities. The environmental entities, after being generated at an initial speed in the preset area of the main entity, are changed to a target speed according to a preset acceleration or deceleration.

According to some embodiments, the target speed constraint comprises a speed range and a distribution rule when each environmental entity reaches a uniform motion within each update period. The speed range comprises the maximum value and the minimum value of the target speeds of a plurality of environmental entities, and the corresponding distribution rule represents the rule followed by the target speed values of the plurality of environmental entities. Within each update period, one or more numbers can be randomly generated according to the speed range and the distribution rule of the target speeds as the target speed of each environmental entity in the period. In general, as many environmental entities as there are within the period, as many target speed values can be randomly generated and assigned to the corresponding environmental entities respectively.

It should be noted that, a set of simulation parameters may be set in the present disclosure, so that a plurality of update periods may adopt the same speed range and distribution rule, that is, the initial speed and the target speed are assigned to a plurality of vehicles within a plurality of update periods under the constraints of the same speed range and distribution rule. A plurality of sets of simulation parameters may also be set in the present disclosure, so that a plurality of update periods may adopt different speed ranges and distribution rules, that is, within different update periods, the initial speed and the target speed are respectively assigned to the plurality of vehicles within each update period under different speed ranges and distribution rules.

According to some embodiments, the acceleration/deceleration constraint comprises an acceleration/deceleration range and a distribution rule of each environmental entity within each update period, respectively. The acceleration/deceleration represents the acceleration/deceleration value that the environmental entity can adopt during the test, and one environmental entity can adopt the same acceleration or deceleration or adopt a plurality of accelerations or decelerations under a plurality of speed changes in the whole test process. The acceleration range and the deceleration range each comprise a maximum value and a minimum value, and the corresponding distribution rule represents the rule followed by the accelerations/decelerations of a plurality of environmental entities.

In addition, in order to be closer to the situation where the vehicle may actually change its speed frequently, the simulation parameters of the present disclosure may further comprise a distribution of speed change road sections including a road section length range and a distribution rule of non-uniform speed traveling of each environmental entity in a one-way driving test from the starting point to the end point. The road section length range comprises a maximum value and a minimum value, and the range value is associated with the length of a test road from the starting point to the end point. The distribution rule comprises the rule followed by the lengths of the speed change road sections of different vehicles within each update period. For example, assuming that the total length from the starting point to the end point is 5 km, in a one-way driving test, vehicle A needs to run for a section of 1 km at a non-uniform speed, vehicle B needs to run for a section of 0.8 km at a non-uniform speed, and vehicle C needs to run for a section divided into kilometers for each environmental entity at a non-uniform speed, and the lengths of speed change road sections of a plurality of vehicles are integrally in accordance with Gaussian distribution.

According to some embodiments, the driving habit parameters comprise at least one of an override distance and a cut-in distance. The override distance comprises a first preset (such as a minimum distance) to be kept between an environmental entity and a front vehicle; the cut-in distance comprises a second preset distance (such as minimum distance) to be kept between the environmental entity and a vehicle on another lane when the environmental entity is moving into the lane. The override distance is obtained through calculation on the basis of a first time to crash, a current speed of the environmental entity and a speed of a front vehicle in a same lane; the cut-in distance is obtained through calculation on the basis of a second time to crash, a current speed of the environmental entity and speeds of a front vehicle and a rear vehicle in another lane.

Among them, the first time to crash and the second time to crash are preset time-to-crash parameters (TTC, i.e., how long there will be a crash). The first time to crash represents how long the vehicle at the current speed will crash a front vehicle, and the second time to crash represents how long the vehicle at the current speed will crash a front vehicle and a rear vehicle which are to move into another lane when the vehicle wants to move into the lane. TTC parameters are set, so that corresponding override distance or cut-in distance can be obtained according to the speed difference of the front vehicle and the rear vehicle.

Optionally, the override distance = a first time to crash × (NPC speed - speed of a front vehicle), the cut-in distance between the vehicle and a front vehicle in a target lane when the vehicle is moving into the target lane = a second time to crash × (speed of the front vehicle in the target lane - NPC speed), and the cut-in distance between the vehicle and a front vehicle in a target lane when the vehicle is moving into the target lane = a second time to crash × (speed of the front vehicle in the target lane - NPC speed).

Each NPC is given priority to keep running at the target speed until it reaches the "override distance" from the front vehicle. At the moment, the vehicle will keep the distance between itself and the front vehicle to be not less than the "override distance" in a deceleration mode, while looking for a chance to move into the left or right lane, and if it finds a lane where the vehicle and the front and rear vehicles in this lane can satisfy both of the "override distance" and the "cut-in distance", the vehicle may choose to move into this lane to get closer to its target speed.

Based on this, the method 200 may further comprise steps of controlling, in response to a distance between the environmental entity and a front vehicle in a same lane being smaller than the override distance, the environmental entity to decelerate until the distance between the environmental entity and the front vehicle in the same lane is not smaller than the override distance; and controlling, in response to a speed of the environmental entity not being a target speed and distances between the environmental entity and front and rear vehicles in another lane simultaneously satisfying the override distance and the cut-in distance, the environmental entity to drive to location between the front vehicle and the rear vehicle in the lane.

Assuming that the first time to crash and the second time to crash of vehicle A are both set to 2 seconds, and the target speed is set to 100 km/h, if the current speed of vehicle A is also 100 km/h, the speed of vehicle B, in front of vehicle A, is 50 km/h, and the override distance of vehicle A to vehicle B is = (100 km/h - 50 km/h) × 2 s = 27.8 m, vehicle A will run forward at a speed of 100 km/h and then starts to decelerate when it is 27.8 meters away from a vehicle at a speed of 50 km/h, at the moment, vehicle A will start to find whether there is an adjacent lane around itself that can both satisfy its override distance and cut-in distance, if YES, it will move into the lane and accelerates to be as close as possible to its target speed of 100 km/h.

If the current speed of vehicle A is 50 km/h, which is not the target speed, and there is no vehicle in the front of vehicle A on the right side, and the speed of vehicle C, at the rear of the right side of vehicle A, is 100 km/h, the cut-in distance of A to C is = (100 km/h - 50 km/h) × 2 s = 27.8 m. If the distance between vehicle A and vehicle C at the moment is greater than 27.8 meters and vehicle A cannot accelerate continuously in its original lane, vehicle A may choose to move into the right lane and accelerates to be as close as possible to its target speed of 100 km/h.

As can be seen, the running logic of the NPC vehicles comprises: priority to keep the distance between the vehicle and the front vehicle in the same lane not less than the override distance, that is, not to crash the front vehicle, wherein if the distance between the two vehicles may be less than the override distance, the NPC vehicle decelerates and re-accelerates until it reaches its target speed if the subsequent override distance allows; if the vehicle cannot reach the target speed in this lane, it will find a chance to move into the left lane or the right lane, and when a lane in which front and rear vehicles are located is found to satisfy both the override distance and the cut-in distance of the vehicle, the vehicle will move to a location between the front vehicle and the rear vehicle in the lane.

According to some embodiments, different weather conditions and road conditions have different simulation parameters, respectively. That is, the behaviors and related parameters of the environmental entities generated in each test task are associated with the weather conditions and road conditions when the test task is performed. Generally, the worse the weather conditions are, or the worse the road conditions are, the more conservative the driving habit of each environmental entity is, i.e., the numerical values of the target speed, the acceleration, the deceleration and the override distance are generally smaller than those when the environment is good, and the cut-in distance is generally greater than those when the environment is good. For example, in a rainy day or a rough road, vehicles generally run at a slow speed with a conservative driving habit, so that the initial speed, the target speed, the acceleration, the deceleration and the override distance of each NPC vehicle are smaller than those in a sunny day or a smooth road.

In addition, the environmental entities may further comprise some unexpected objects commonly encountered in the road driving process, such as animals and plastic bags flying in the air. In the present disclosure, one or more unexpected objects may be randomly generated in a preset area of a main entity during a certain test process. For example, one or two test tasks are randomly selected every day. In the test task, one or more time points are randomly selected from the road section where the main entity travels from the starting point to the end point, and a small animal is generated and displayed in front of the main entity so as to test the detection and avoidance capacity of the main entity on the unexpected object.

According to some embodiments, each batch of the generated environmental entities run in a test map according to preset simulation parameters, the main entity can perform corresponding to the calculation results of the autonomous driving algorithm on the simulation platform, so as to interact with the environmental entities, thereby forming a simulation test task. Therefore, an autonomous driving simulation task comprises a test map, the test map comprises a simulation starting point and a simulation end point, an autonomous driving system to be tested, and simulation parameters of NPC vehicles. The test map may be selected from the simulation platform. After a test task is started, the main entity runs between the starting point and the end point, a plurality of environmental entities are generated around the main entity in batches according to the preset update period and number distribution, and after the environmental entities are generated at an initial speed, the environmental entities reach a target speed through acceleration or deceleration until the environmental entities disappear after satisfying the disappearing conditions.

According to some embodiments, the method 200 may further comprise the step of controlling, in response to the environmental entities or the main entity reaching the simulation end point, the environmental entities or the main entity to turn around to travel towards the starting point, or moving the environmental entities or the main entity to the simulation starting point, so as to trigger a test of a next journey. Or, the present disclosure may be configured with a plurality of test maps in advance, and in response to the main entity running to a simulation end point of the current map, the main entity may automatically enter the next preset test map to start a new test journey, and such process is repeated. In this way, even if the main entity arrives at the test end point, the test of the present disclosure will not be stopped. However, the vehicle continues to turn around to be tested or goes back to the test starting point or enters into the next map test, so that a full-automatic 24/7 (i.e., 7*24h) test is realized without manual operation.

In addition, the present disclosure can also select its own test duration of each test task, and the default running duration of each running task can be set as a fixed duration or an infinite duration. For the former one, the test is automatically stopped after the fixed duration and the test results are recorded; for the latter one, the wireless test is circulated at all times and the test results are output in time.

It should be noted that, during the test process, it is inevitable that an abnormality, such as a crash, occurs in each agent, and at the moment, the environmental entity may be removed from the simulation platform in response to an abnormality occurring in the environmental entity. Further, it is considered that existing vehicles usually take some time to move out of the road after a crash. Therefore, the method 200 may further comprise the following step: removing, in response to an abnormality occurring in the environmental entities, the environmental entities from the simulation platform after waiting for a preset time. In the above step, the abnormalities of the environmental entities include, but are not limited to: a crash, driving out of the test map, driving out of the preset area of the main entity, etc.

In addition, it is considered that the environmental entities driving out of the preset area of the main entity does not actually have a significant impact on the running of the main entity. Therefore, the method 200 may further comprise the following step: removing, in response to the environmental entities driving out of the preset area of the main entity, the environmental entities from the simulation platform. Thus, the data operation amount can be reduced, and unnecessary data operation and display can be reduced.

It should be understood that one of the primary objectives of the present disclosure is to test the virtual autonomous driving system or autonomous driving algorithm of the main entity in the simulation platform, naturally with the corresponding test evaluation index, to evaluate whether the main entity is running properly. Optionally, the method 200 may further comprise steps of:
B 1: evaluating, according to a preset evaluation index, whether an abnormality occurs in the main entity within each simulation period; and
B2: recording, in response to an abnormality occurring in the main entity, scene information within a preset time period before and after the abnormality of the main entity, i.e., scene information within a preset time period within the abnormality in the main entity.

In the above steps, the abnormalities of the main entity in the step B1 include, but are not limited to, a crash, driving out of a test map, a failure of the autonomous driving system, a failure of the autonomous driving algorithm, speeding, a sudden stop, and an abnormality in a broadcasting frequency of a warning tone. The failure of the autonomous driving system comprises algorithm failures of different nodes, such as perception failure, path planning failure, and control failure. Accordingly, the evaluation index (i.e., the validation rule) comprises an evaluation of whether a crash occurs, whether a vehicle drives out of a map, whether the autonomous driving system fails, whether overspeeding occurs, whether a sudden stop occurs, and whether an abnormality occurs in a broadcasting frequency of a warning tone. An abnormality occurring in a broadcasting frequency of a warning tone comprises, for example, frequently broadcasting for multiple times in a period of time.

The scene information recorded in the step B2 comprises locations and speeds of the main entity and the environmental entities at different moments within the preset time period, and various other parameters of the main entity and the environmental entities, such as the vehicle dimension, the vehicle type, and the vehicle body direction. The preset time period, for example, each 15 seconds before and after the occurrence of an abnormality, can facilitate the subsequent analysis of the cause of the abnormality by recording the scene information within each 15 seconds before and after the occurrence of the abnormality with emphasis. The recorded scene information can also be used as an annotation data set to supplement the annotation data of the algorithm data set.

Every simulation period is, for example, a period for every one hour. Simulation period can also be one to more update period, such as 4 update periods. The present disclosure evaluates, on an hourly basis, whether an abnormality occurs with the main entity during the period. If an abnormality occurs in the period, the preset time period before and after the abnormality occurs in the period is recorded with emphasis. If no abnormality occurs in the period, no key record is made. On the basis that a 24/7 uninterrupted simulation can be realized in the present disclosure, the simulation results are recorded according to the simulation period, so that the simulation efficiency can be effectively improved to facilitate the analysis of the simulation results.

Further, the step B 1 of evaluating, according to a preset evaluation index, whether an abnormality occurs in the main entity within each simulation period comprises: evaluating, according to the evaluation index, whether an abnormality occurs in the main entity in each simulation picture within each simulation period. Here, the simulation results are analyzed in frames, and each frame of the simulation picture gives a result of determining whether an abnormality occurs in the main entity. If an abnormality occurs in the main entity in a certain frame within a simulation period, it represents that the frame is abnormal, and a preset number of frames before and after the frame are recorded for subsequent analysis of results.

That is, the present disclosure splits the results of each running task by hour, with a total of two forms: the first form is the result of "validation rule", such as whether the main entity sent the information such as a crash and speeding every hour; the second form is "simulation video and verification rule result of each frame". The simulation video can be played frame by frame, and after each evaluation index is selected, the success or failure of each frame of the evaluation index is displayed on a progress bar. If an evaluation index in the current frame fails, the frame is marked as "failure", and if all the evaluation indexes are normal, the frame is marked as "success". Of course, those skilled in the art can also design other ways to evaluate normality or failure, such as a weighted average using multiple indexes, which is not limited in the present disclosure.

According to the technical solutions of the present disclosure, the thinking limitation of manually compiling the test cases is solved. The simulation platform can automatically generate the test cases according to the configuration information, and an interactive scene which cannot be generated manually can also be made, such as the interaction between various vehicles in a special scene. Moreover, the efficiency of manually compiling the test cases is limited. Test cases accumulated by a 10-person team for years can run out quickly under high calculation force, and the test cases automatically generated in the present disclosure can run for a long time, so that the mileage of simulation test is greatly increased. In addition, some test scenes can be stored as a good test case in the test process and used as a portion of an "annotation test set", so that the simulation test is improved.

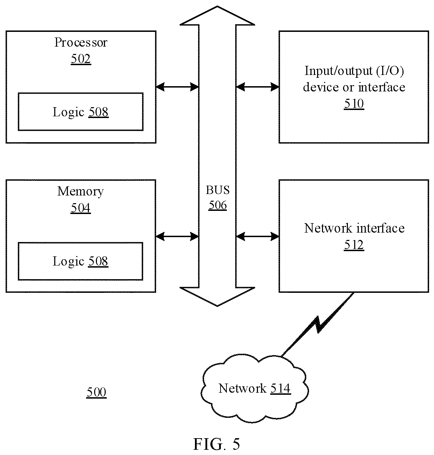

FIG. 5 illustrates a schematic of a machine in the example form of a computing device 500 (which can be used as the simulation platform, as well as the inputting device, the display device and the simulation device of the simulation platform) in which an instruction set, when executed, and/or a processing logic, when initiated, may cause the machine to implement any one or more of the methods described and/or claimed herein. In alternative embodiments, the machine operates as a standalone device or may be connected (e.g., networked) to other machines. In a networked deployment, the machine may operate in the identity of either a server or a client machine in server-client network environments, or as a peer machine in peer-to-peer (or distributed) network environments. The machine may be a personal computer (PC), a laptop computer, a tablet computing system, a personal digital assistant (PDA), a cellular phone, a smartphone, a network application, a set-top box (STB), a network router, a switch or bridge, or any machine capable of executing the instruction set (sequentially or otherwise) that specify actions to be taken by that machine or initiating the processing logic. Further, although only a single machine is illustrated, the term "machine" may also be understood to encompass any combination of machines that individually or jointly execute an instruction set (or a plurality of instruction sets) to perform any one or more of the methods described and/or claimed herein.

The exemplary computing device 500 may comprise a data processor 502 (e.g., a System on Chip (SoC), a general-purpose processing core, a graphics core, and other optional processing logic) and a memory 504 (e.g., storage) that may communicate with each other via a bus 506 or other data transfer system. The computing device 500 may also comprise various input/output (I/O) devices and/or interfaces 510, such as a touch-screen display, an audio jack, a voice interface, and an optional network interface 512. In exemplary embodiments, the network interface 512 may comprise one or more radio transceivers configured for use with any one or more standard wireless and/or cellular protocols or access technologies (e.g., second generation (2G), 2.5 generation, third generation (3G), fourth generation (4G), and next-generation radio access of cellular systems, Global System for Mobile Communications (GSM), General Packet Radio Service (GPRS), Enhanced Data GSM Environment (EDGE), Wideband Code Division Multiple Access (WCDMA), LTE, CDMA2000, WLAN, Wireless Router (WR) mesh and the like). The network interface 512 may also be configured for use with various other wired and/or wireless communication protocols (including TCP/IP, UDP, SIP, SMS, RTP, WAP, CDMA, TDMA, UMTS, UWB, WiFi, WiMax, Bluetooth^{©}, IEEE802. 1 1x and the like). In essence, the network interface 812 may virtually comprise or support any wired and/or wireless communication and data processing mechanism by which information/data may be propagated between the computing device 500 and another computing or communication system via network 514.

The storage 504 may represent a machine-readable medium (or computer-readable storage medium) on which one or more instruction sets, softwares, firmwares, or other processing logics (e.g., logic 508) for performing any one or more of the methods or functions described and/or claimed herein. The logic 508 or a portion thereof, when executed by the computing device 500, may also completely or at least partially reside in the processor 502. Therefore, the memory 504 and the processor 502 may also constitute the machine-readable medium (or computer-readable storage medium). The logic 508 or the portion thereof may also be configured as a processing logic or a logic, of which at least a portion is partially implemented in hardware. The logic 508 or the portion thereof may also be transmitted or received through the network 514 via the network interface 512. Although the machine-readable medium (or computer-readable storage medium) of the exemplary embodiments may be a single medium, the term "machine-readable medium" (or computer-readable storage medium) may be understood to comprise a single non-transitory medium or multiple non-transitory media (e.g., a centralized or distributed database, and/or an associated cache and computing system) that store one or more instruction sets. The term "machine-readable medium" (or computer-readable storage medium) may also be understood to comprise any non-transitory medium that is capable of storing, encoding or carrying an instruction set for execution by the machine and that cause the machine to perform any one or more of the methods of the various embodiments or that is capable of storing, encoding or carrying data structures utilized by or associated with such an instruction set. The term "machine-readable medium" (or computer-readable storage medium) may accordingly be taken to comprise, but not be limited to, solid-state memories, optical media, and magnetic media.

The disclosed and other embodiments, modules, and functional operations described herein may be implemented in digital electronic circuitry, or in computer software, firmware or hardware (including the structures disclosed herein and structural equivalents thereof), or in combinations of one or more. The disclosed and other embodiments may be implemented as one or more computer program products, that is, one or more modules of computer program instructions encoded on a computer-readable medium for execution by, or control of the operation of, data processing apparatus. The computer-readable medium may be a machine-readable storage device, a machine-readable storage substrate, a memory device, a composition of matter impacting machine-readable propagated signals, or a combination of one or more. The term "data processing apparatus" encompasses all apparatus, devices, and machines for processing data, including, for example, a programmable processor, a computer, or multiple processors or computers. In addition to hardware, the apparatus may further comprise codes that create an execution environment for the computer program in question, e.g., codes that constitute processor firmware, a protocol stack, a database management system, an operating system, or a combination of one or more. A propagated signal is an artificially generated signal (e.g., a machine-generated electrical, optical, or electromagnetic signal) that is generated to encode information for transmission to suitable receiver apparatus.

A computer program (also referred to as a program, software, a software application, a script, or a code) may be written in any form of programming language (including compiled languages or interpreted languages), and the computer program may be deployed in any form, including as an independent program or as a module, a component, a subroutine, or another unit suitable for use in a computing environment. A computer program does not necessarily correspond to a file in a file system. A program can be stored in a portion of a file that holds other programs or data (e.g., one or more scripts stored in a markup language document), stored in a single file dedicated to the program in question, or stored in multiple collaborative files (e.g., files that store one or more modules, sub programs, or portions of code). A computer program may be deployed for execution on one computer or on multiple computers that are located at one site or distributed across multiple sites and interconnected by a communication network.

The processes and logic flows described herein may be executed by one or more programmable processors executing one or more computer programs to perform functions by operating on input data and generating output. The processes and logic flows may also be executed by, and the apparatus may also be implemented as, a special purpose logic circuitry (e.g., an FPGA (field-programmable gate array) or an ASIC (application-specific integrated circuit)).

Processors suitable for executing a computer program comprise, for example, both general-purpose microprocessors and special purpose microprocessors, and any one or more processors of any kind of digital computer. Generally, a processor will receive instructions and data from a read-only memory or a random access memory or both. The necessary elements of a computer are a processor for executing instructions and one or more memory devices for storing instructions and data. Generally, a computer may also comprise one or more mass-storage devices for storing data (e.g., magnetic disks, magneto-optical disks, or optical disks), or the computer may also be operatively coupled to receive data from or transfer data to the one or more mass-storage devices, or both. However, the computer does not necessarily have such devices. Computer-readable media suitable for storing computer program instructions and data comprise all forms of non-volatile memory, media and memory devices, including, e.g., semiconductor memory devices (e.g., EPROM, EEPROM, and a flash memory device), magnetic disks (e.g., an internal hard disk or a removable disk), magneto-optical disks, and CD-ROM disks and DVD-ROM disks. The processor and the memory can be supplemented by, or incorporated in, the special purpose logic circuitry system.

Although the present disclosure contains many details, these should not be construed as limitations on the scope of the present disclosure or of what may be claimed, but rather as descriptions of features specific to particular embodiments of the present disclosure. Certain features that are described herein in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially required, one or more features from a required combination may in some cases be excised from the combination, and the required combination may be directed to a subcombination or variation of a subcombination.

Similarly, although operations are depicted in the drawings in a particular order, this should not be understood as requiring that such operations be executed in a particular order shown or in a sequential order, or that all illustrated operations be executed, to achieve desirable results. Moreover, the separation of various system components in the embodiments described herein should not be understood as requiring such separation in all embodiments.

Only some implementations and examples are described and other implementations, enhancements and changes may be made based on what is described and illustrated herein.

The illustrations of embodiments described herein are intended to provide a general understanding of the structure of various embodiments, and they are not intended to serve as a complete description of all of the elements and features of components and systems that may utilize the structures described herein. Many other embodiments will be apparent to those of ordinary skill in the art upon reviewing the description provided herein. Other embodiments may be utilized and derived, such that structural and logical replacements and changes may be made without departing from the scope of this disclosure. The drawings herein are merely representational and may not be drawn to scale. Certain proportions may be exaggerated, while other proportions may be minimized. Accordingly, the specification and drawings are to be regarded as illustrative rather than restrictive.

Some embodiments implement functions in two or more particular interconnected hardware modules or devices with related control and data signals conveyed among and through modules, or as portions of an application-specific integrated circuit. Accordingly, the exemplary systems are applicable to software, firmware, and hardware implementations.

Although exemplary embodiments or examples of the present disclosure have been described with reference to the accompanying drawings, it should be understood that the above exemplary discussion is not intended to be exhaustive or to limit the present disclosure to the precise forms disclosed. Many modifications and variations are possible in view of the above teachings. Therefore, the disclosed subject matter should not be limited to any single embodiment or example described herein, but rather should be construed in breadth and scope in accordance with the appended claims.

## Claims

1. A simulation method, comprising:
generating a main entity in a simulation platform;
acquiring simulation parameters of environmental entities, the simulation parameters comprising update periods of the environmental entities and a number constraint of the environmental entities in a preset area where the main entity is located within each update period;
determining, according to the number constraint, an expected number of the environmental entities in the preset area where the main entity is located within each update period; and
generating, according to the simulation parameters and the expected number, a corresponding number of the environmental entities in the preset area of the main entity within each update period.

2. The method according to claim 1, wherein:
the number constraint comprises a range of values for the expected number and a distribution rule with which a plurality of expected number values of a plurality of update periods comply; and
different weather conditions and road conditions respectively have different simulation parameters.

3. The method according to claim 1 or 2, wherein determining, according to the number constraint, the expected number of the environmental entities in the preset area where the main entity is located within each update period comprises at least one of:
in response to an arrival of an update moment of each update period, determining, according to the number constraint, the expected number of the environmental entities in the preset area where the main entity is located within the update period; or
determining in advance, according to the number constraint, the expected number of the environmental entities in the preset area where the main entity is located within each update period so as to obtain a plurality of expected numbers corresponding to a plurality of update periods.

4. The method according to any one of claims 1-3, wherein generating the corresponding number of the environmental entities in the preset area where the main entity is located within each update period comprises:
calculating, within each update period, an actual number of the environmental entities in the preset area where the main entity is located and a difference value between the actual number and the expected number;
generating, in response to the difference value being a positive number, new environmental entities with a number of the difference value in the preset area where the main entity is located; and
postponing, in response to the difference value being a negative number, the execution of the update operation of a current update period, and determining, according to the actual number of the environmental entities in the preset area where the main entity is located within the current update period, whether to generate a new environmental entity.

5. The method according to any one of claims 1-4, wherein the simulation parameters further comprise at least one of a location constraint, a type constraint, a dimension constraint, an initial speed constraint, a target speed constraint, an acceleration constraint, a deceleration constraint and driving habit parameters of the environmental entities in the preset area where the main entity is located within each update period.

6. The method according to any one of claims 1-5, wherein the simulation parameters further comprise a location constraint, the location constraint comprises at least one of:
a relative location of each environmental entity relative to the main entity when each environmental entity being generated, or
an offset value of each environmental entity relative to a lane center when each environmental entity being generated;
wherein the relative location comprises at least one of left front, straight ahead, right front, left side, right side, left back, directly behind, and right back.

7. The method according to any one of claims 1-6, wherein the simulation parameters further comprise driving habit parameters, the driving habit parameters comprise at least one of an override distance and a cut-in distance;
the override distance comprises a first preset distance to be kept between the environmental entity and a front vehicle;
the cut-in distance comprises a second preset distance to be kept between the environmental entity and a vehicle in another lane when the environmental entity is moving into the another lane.

8. The method according to claim 7, wherein
the override distance is obtained based on a first time to crash, a current speed of the environmental entity and a speed of a front vehicle in a same lane;
the cut-in distance is obtained based on a second time to crash, the current speed of the environmental entity and speeds of a front vehicle and a rear vehicle in another lane.

9. The method according to claim 7, further comprising:
controlling, in response to a distance between the environmental entity and a front vehicle in a same lane being smaller than the override distance, the environmental entity to decelerate until the distance between the environmental entity and the front vehicle in the same lane is not smaller than the override distance.

10. The method according to claim 7, further comprising:
controlling, in response to a speed of the environmental entity not being a target speed and distances between the environmental entity and front and rear vehicles in another lane simultaneously satisfying the override distance and the cut-in distance, the environmental entity to drive to location between the front vehicle and the rear vehicle in the lane.

11. The method according to any one of claims 1-10, wherein the simulation parameters further comprise a simulation starting point and a simulation end point of a test map, the method further comprising at least one of:
controlling, in response to the environmental entities or the main entity reaching the simulation end point, the environmental entities or the main entity to turn around to travel towards the simulation starting point, or moving the environmental entities or the main entity to the simulation starting point;
removing, in response to an abnormality occurring in the environmental entities, the environmental entities from the simulation platform after waiting for a preset time; or
removing, in response to the environmental entities driving out of the preset area of the main entity, the environmental entities from the simulation platform.

12. The method according to any one of claims 1-11, further comprising:
evaluating, according to a preset evaluation index, whether an abnormality occurs in the main entity within each simulation period, comprising:
evaluating, according to the evaluation index, whether the abnormality occurs in the main entity in each simulation picture within each simulation period; and
recording, in response to the abnormality occurring in the main entity, scene information within a preset time period within the abnormality occurs in the main entity;

13. The method according to claim 12, wherein
the abnormality comprises at least one of the following: a crash, a vehicle driving out of a test map, a failure of an autonomous driving algorithm, overspeeding, a sudden stop, and an abnormality in a broadcasting frequency of a warning tone;
the scene information comprises locations and speeds of the main entity and the environmental entities at different moments within the preset time period.

14. A computing device, comprising:
a processor, a memory, and a computer program stored on the memory and executable on the processor;
wherein the processor, when executing the computer program, performs a method according to any one of claims 1 to 13.

15. A computer-readable storage medium having a computer program stored thereon, wherein the computer program, when executed by a processor, causes the computing device to implement a method according to any one of claims 1 to 13.
